# EUROPÄISCHE PATENTSCHRIFT

(11) **EP 2 856 189 B1**
(45) Veröffentlichungstag und Bekanntmachung des Hinweises auf die Patenterteilung: **14.09.2016**
(21) Anmeldenummer: 13725917.2
(22) Anmeldetag: 17.05.2013
(51) Int. Cl.: G01R 31/36

(54) **VERFAHREN UND VORRICHTUNG ZUM FESTSTELLEN DER TATSÄCHLICHEN KAPAZITÄT EINER BATTERIE**
METHOD AND DEVICE FOR DETERMINING THE ACTUAL CAPACITY OF A BATTERY
PROCÉDÉ ET DISPOSITIF POUR LA DÉTERMINATION DE LA CAPACITÉ RÉELLE D'UNE BATTERIE

(30) Priorität: 26.05.2012 DE 102012010487
(43) Veröffentlichungstag der Anmeldung: 08.04.2015
(73) Patentinhaber: Audi AG, 85045 Ingolstadt (DE)
(72) Erfinder: NAUMANN, Rolf, 96247 Michelau (DE)
(74) Vertreter: Herbst, Matthias Heinz
(86) Internationale Anmeldenummer: PCT/EP2013/001483
(87) Internationale Veröffentlichungsnummer: WO 2013/178329

(56) Entgegenhaltungen:
- EP-A2- 0 410 716
- EP-A2- 1 754 978
- WO-A1-86/00418
- US-B1- 6 174 617

## Beschreibung

Die vorliegende Erfindung betrifft ein Verfahren und eine Vorrichtung zum Bewerten eines Alterungszustands einer Batterie unter Verwendung einer Batteriekennlinie.

In einem Kraftfahrzeug, bei dem eine Batterie (= wiederaufladbare elektrische Energiequelle; Sekundärbatterie bzw. Akkumulator) als alleinige oder neben einer Verbrennungskraftmaschine als weitere Energiequelle zum Antrieb des Fahrzeugs Verwendung findet (Elektrofahrzeug, Hybrid-Fahrzeug), kommt der Kapazität der Batterie eine wichtige Rolle für die Reichweite des Kraftfahrzeugs zu, die dieses ohne erneute Aufladung der Batterie zurücklegen kann.

Es ist eine bekannte Tatsache, dass sich die entnehmbare Energiemenge, d. h. entnehmbare Strommenge beispielsweise eines derzeit erhältlichen Lithiumionen-Akkumulators mit zunehmendem Alter und/oder Anzahl an Lade- und Entladezyklen verringert.

Dieser Kapazitätsverlust, der umgangssprachlich allgemein als Alterung bezeichnet wird und eine Ausprägung der Änderung des Verhaltens von Batterien im Lade- und Entladebetrieb (bestimmungsgemäßer Einsatz) oder durch kalendarische Alterung ist, kann derzeit nur unzureichend bestimmt werden.

Die bekannten Verfahren zur Bestimmung des Kapazitätsverlusts sind entweder sehr komplex und/oder schwer parametrierbar (z. B. bei Impedanzermittlungen) oder verwendete Alterungsmodelle sind nicht vollständig bzw. ausreichend parametriert und das kann zu erheblichen Abweichungen in der Berechnung führen.

Einfache Verfahren haben meist den Nachteil, dass wichtige Parameter nicht berücksichtigt werden können oder auch einfach nicht bekannt sind (z. B. die Verlustleistung bzw. ein Wirkungsgrad, der über die Lebensdauer und den Einsatz der Batterien nicht konstant zu sein braucht).

Eine dedizierte Aussage über den aktuellen Energieinhalt, also die tatsächlich verfügbare Strommenge, kann im laufenden Betrieb daher nicht einfach gemacht werden. Da die Batteriekapazität sich durch die Ausprägung von Alterung reduziert, werden aber bei nicht richtig nachgeführter tatsächlicher (bzw. korrigierter) Batteriekapazität Aussagen über Verfügbarkeiten fehlschlagen bzw. ungenau sein.

Viele der bekannten Verfahren zur Bestimmung der aktuellen Kapazität einer Batterie erfordern die Ermittlung von Ladungszuständen (State of Charge, SOC) der Batterie, die auf Messungen von Ruhespannungen (Open Circuit Voltage, OCV) der Batterien basieren, sowie der Messung der zwischen zwei Ladungszuständen entnommenen Strommenge.

So beschreibt beispielsweise die EP 1 314 992 A2 eine Vorrichtung und ein Verfahren zum Bestimmen der Kapazität eines zum Antrieb eines Elektroautos bestimmten Akkumulators, bei dem über die jeweiligen Ruhespannungen im lastfreien Zustand ein erster Ladungszustand des Akkumulators und ein zweiter Ladungszustand des Akkumulators ermittelt werden, und aus der zwischen den zwei Ladungszuständen geflossenen Entlade-Strommenge die tatsächliche Kapazität des Akkumulators bestimmt wird.

Aus der DE 10 2007 037 041 A1 ist ein Verfahren und eine Vorrichtung zu Batteriezustandserkennung einer Säure-Batterie unter Verwendung eines abgespeicherten Batteriemodells bekannt. Dabei wird die Ruhespannung der Säure-Batterie in Abhängigkeit von der der Batterie entnehmbaren Ladung in Form einer Kennlinie hinterlegt. Es erfolgt eine Ermittlung eines ersten Parameters, der den durch die Alterung der Batterie und eine Säureschichtung der Batterie verursachten Kapazitätsverlust der Batterie beschreibt. Weiterhin wird ein zweiter Parameter ermittelt, der Auskunft über die Steigung der Kennlinie gibt. Ferner erfolgt eine Adaption der gespeicherten Kennlinie unter Berücksichtigung des ersten und des zweiten Parameters.

Gemäß dieser Druckschrift erfolgt die Ermittlung der entnehmbaren Energiemenge und der tatsächlichen Kapazität einer Säure-Batterie durch Ermittlung einer Ruhespannungs-Amperestunden-Kennlinie. Im Vergleich zu einer neuen Batterie ohne Säureschichtung ist bei einer gealterten Batterie die Kennlinie parallel nach oben verschoben, und bei einer Batterie mit Säureschichtung weist die Kennlinie eine vergrößerte Steigung auf. Die Ruhespannungs-Amperestunden-Kennlinie kann durch Messung der Batterie-Ruhespannung vor und nach einer Entladung erfasst werden. Eine Adaption der gespeicherten Kennlinie erfolgt dann unter Verwendung der tatsächlich ermittelten Spannungs-Amperestunden-Kennlinie.

Die DE 10 2010 006 965 A1 beschreibt ein Verfahren zur Bestimmung wenigstens eines Bereichs einer Batteriekennlinie für eine Batterie in einem Fahrzeug wobei der aktuelle Ladungszustand der Batterie aus gemessenen Batterieparametern bestimmt wird, ein Verschiebungswert aus der Differenz eines gemessenen Batterieparameters und eines Standard-Werts, welcher aus einer Standard-Batteriekennlinie unter Berücksichtigung des bestimmten Landungszustands ermittelt wird, bestimmt wird, und wenigstens ein Bereich einer neuen Batteriekennlinie durch Addition des Verschiebungswertes zu der Standard-Batteriekennlinie ermittelt wird.

Gemäß dieser Druckschrift erfolgt eine Bestimmung der aktuellen Batteriekennlinie durch Messung von Leerlaufspannungen nach einer längeren Ruhephase der Batterie bei verschiedenen Ladungszuständen einer Batterie. Die Abweichung der aktuellen Batteriekennlinie (Leerlaufspannungs-aktueller Ladungszustand-Kennlinie) von der Batteriekennlinie einer "Standard-Batterie" wird aufgrund eines Vergleichs der jeweiligen Ruhespannungen bei gegebenen Ladungszuständen bzw. aufgrund eines Vergleichs von jeweili-gen Ladungszuständen bei gegebenen Ruhespannungen ermittelt.

Aus der JP 2002-243 813 A ist eine Recheneinheit bekannt, die eine Veränderung des Ladungszustandes eines Akkumulators aus dem über die Zeit integrierten Entladestrom des Akkumulators auf Grundlage der Leerlaufspannungen am Integrationsstartzeitpunkt und am Integrationsendzeitpunkt, sowie die Korrelation zwischen den Leerlaufspannungen und dem Ladungszustand des Akkumulators berechnet. Weiter berechnet die Recheneinheit die mit der Zeit eingetretene verschlechterte Kapazität des Akkumulators auf Grundlage eines integrierten Entladestromwerts, der auf Grundlage des Entladestroms und der Veränderung des Ladungszustands berechnet wird. Darüber hinaus berechnet die Recheneinheit die Kapazitäts-Verschlechterungs-Rate auf Grundlage der mit der Zeit eingetretenen verschlechterten Kapazität und der anfänglichen Kapazität des Akkumulators.

Wie aus dieser kurzen Übersicht zu entnehmen ist, ist bei allen oben beschriebenen Verfahren und Vorrichtungen die Messung eine Ruhespannung (Open Circuit Voltage, OCV) der Batterie erforderlich. Diese Ruhespannung kann mit hinreichender Genauigkeit jedoch nur gemessen werden, wenn nach dem Ende eines Entladevorgangs eine nicht unbeträchtliche Zeitdauer vergangen ist. So ist beispielsweise aus Fig. 6 von EP 1 314 992 A2 entnehmbar, dass eine Ruhephase von bis zu 3000 Sekunden, also von bis zu 50 Minuten erforderlich sein kann, bis die Spannung nach der Beendigung eines Entladevorgangs einen stabilen Wert angenommen hat.

Die US 6,174,617 B1 beschreibt unter anderem ein Berechnungsverfahren für die Gesamtkapazität einer Batterie nach einer Anzahl an Ladevorgängen. Bspw. überwacht eine CPU den Anstieg der Klemmenspannung der Batterie während des Ladevorgangs auf einen vorgegebenen Wert in einem bestimmten Bereich, bestimmt die während dieser Zeit geladene Kapazität (mAh) auf der Basis der Zeit, die zur Erhöhung der Klemmenspannung auf einen vorbestimmten Wert in diesem Bereich erforderlich war, und den Ladestromwert zu dieser Zeit, vergleicht diese Kapazität mit dem anfänglichen Kapazitätswert, der durch Durchführung eines ähnlichen Verfahrens wie vorstehend erhalten wurde, und bestimmt die gegenwärtige Gesamtkapazität unter Verwendung dieses Vergleichswerts.

Die EP 1 754 978 A2 hat eine Vorrichtung zum Abschätzen der Restkapazität einer Batterie zum Gegenstand. Die Vorrichtung reduziert die Ausgangsspannung eines Gleichrichters zu einer tatsächlichen Last, misst den elektrischen Strom, der von dem Gleichrichter und der Batterie zu der tatsächlichen Last und einer Dummy-Lastvorrichtung fließt, die getrennt von der tatsächlichen Last vorgesehen ist, steuert die Last der Dummy-Lastvorrichtung derart, dass der gemessene Strom einen vorbestimmten Wert aufweist, und berechnet die Restkapazität der Batterie auf Grundlage der Klemmenspannung der Batterie und der Entladungszeit der Entladung der Batterie zu der tatsächlichen Last und der Dummy-Lastvorrichtung, unter Bezug auf Batteriedaten, welche das Verhältnis zwischen der Entladungszeit der Batterie, der Klemmenspannung der Batterie und der verbleibenden Kapazität der Batterie bei einem vorbestimmten Strom der Batterie angeben.

Die WO 86/00418 beschreibt ein Verfahren zur Überwachung des Ladezustands von wiederaufladbaren Batterien. Hierbei wird in einem Speicher ein einem bestimmten Ladezustand entsprechender Referenzwert gespeichert.

Die Klemmenspannung, die Stromstärke und die Zeit werden während jedes Lade- und Entladezyklus der Batterie gemessen und unter Berücksichtigung der Stromrichtung in eine der zugeführten bzw. verbrauchten Energiemenge entsprechende Größe umgesetzt. Ausgehend von dem gespeicherten Referenzwert werden aus dieser Größe die Ladezustands-Istwerte berechnet. Der charakteristische Verlauf der Klemmenspannungskennlinie beim Laden und Entladen wird zur Minimierung der Abweichungen der Messwerte vom effektiven Ladezustand der überwachten Batterie ausgenutzt, indem die Änderungsgeschwindigkeit der Klemmenspannung im Lade- und Entladezyklus überwacht wird, nach Durchlaufen einer Phase relativ gleichmäßiger und geringer Spannungsänderungsgeschwindigkeit wenigstens ein Zeitpunkt bestimmt wird, bei dem eine stärkere Spannungsänderungsgeschwindigkeit auftritt, und der coulometrisch ermittelte Ladezustands-Istwert zu diesem Zeitpunkt auf den vorgegebenen Referenzwert abgeglichen wird.

Und aus der EP 0 410 716 A2 ist eine Stromversorgung bekannt, die von einer externen Stromquelle und einer Batterie mit Energie versorgt wird, und elektrische Leistung an eine Last liefert. Die Stromversorgung enthält einen Batteriespannungsdetektor und einem Stromdetektor zum Erfassen eines Entladestroms der Batterie. Die Verbleibende Kapazität der Batterie wird in Übereinstimmung mit einer Änderung der Batteriespannung ermittelt, wenn die externe Energiequelle keinen Stromausfall aufweist. Die Änderung der Batteriespannung ist definiert als die Differenz zwischen einer anfänglichen Spannung der Batterie und einer aktiven Spannung, die erhalten wird, wenn die Batterie durch den erfassten Entladestrom für eine vorbestimmte Zeitdauer entladen wird.

Es ist Aufgabe der vorliegenden Erfindung, ein Verfahren und eine Vorrichtung zum Bewerten eines Alterungszustands einer Batterie zur Verfügung zu stellen, durch die die Nachteile des Stands der Technik überwunden werden.

Diese Aufgabe wird gelöst und weitere Vorteile werden erzielt durch das Verfahren gemäß Anspruch 1 und die Vorrichtung gemäß Anspruch 9 Vorteilhafte Weiterbildungen der Erfindung sind Gegenstand der Unteransprüche.

Das erfindungsgemäße Verfahren zum Feststellen der tatsächlichen Kapazität einer Batterie erfolgt unter Verwendung eines Kennlinienfelds, wobei am Anfang eines Ladevorgangs die Anfangsspannung (UL_{Beginn}) der Batterie, die Ladestromstärke und die Temperatur der Batterie ermittelt werden, hieraus durch Vergleich mit den im Kennlinienfeld vorhandenen Daten eine Kennlinie ausgewählt und ein Anfangszustand der Batterie festgelegt werden, am Ende des Ladevorgangs die Schlussspannung (UL_{Mess}) der Batterie gemessen wird, und die Schlussspannung (UL_{Mess}) mit der aufgrund der gewählten Kennlinie und unter Berücksichtigung der aufgenommenen Ladestrommenge erwarteten Spannung (UL_{Erwartet}) am Ende der Ladung verglichen und für den Fall, dass die Schlussspannung (UL_{Mess}) größer als die aufgrund der gewährten Kennlinie erwarteten Spannung (UL_{Erwartet}) am Ende des Ladevorgangs ist, festgestellt wird, dass die tatsächliche Kapazität der Batterie kleiner ist als die am Anfang des Ladevorgangs angenommene entnehmbare Kapazität,
am Anfang eines Entladevorgangs die Anfangsspannung (UE_{Beginn}) der Batterie, die Entladestromstärke und die Temperatur der Batterie ermittelt werden,
hieraus durch Vergleich mit den im Kennlinienfeld vorhandenen Daten eine Kennlinie ausgewählt und ein Anfangszustand der Batterie festgelegt werden,
am Ende des Entladevorgangs die Schlussspannung (UE_{Mess}) der Batterie gemessen wird,
die Schlussspannung (UE_{Mess}) mit der aufgrund der gewählten Kennlinie erwarteten Spannung (UE_{Erwartet}) am Ende der Entladung verglichen wird und
für den Fall, dass die Schlussspannung (UE_{Mess}) kleiner als die aufgrund der gewählten Kennlinie erwartete Spannung (UE_{Erwartet}) am Ende des Entladevorgangs ist, festgestellt wird, dass die tatsächliche Kapazität der Batterie kleiner ist als die am Anfang des Entladevorgangs angenommene entnehmbare Kapazität, und
die Ergebnisse des Ladevorgangs und die Ergebnisse des Entladevorgangs gleichwertig für die Feststellung der tatsächlichen Kapazität der Batterie berücksichtigt werden.

Das erfindungsgemäße Verfahren zeichnet sich dadurch aus, dass zur Bewertung des Alterungszustands einer Batterie keine Ruhespannung (Open Circuit Votage, OCV) gemessen werden muss, das Verfahren bei normalen Einsatzzwecken verwendbar ist, einfach anzuwenden ist, da es keine speziellen Testmodi oder -prozeduren benötigt, und nicht auf komplizierten Parametern und/oder Modellen beruht. Durch das erfindungsgemäße Verfahren kann somit im laufenden Betrieb auf einfache Weise eine dedizierte Aussage über den aktuellen Energieinhalt einer Batterie gemacht werden. Aufgrund der durch das erfindungsgemäße Verfahren richtig nachgeführten tatsächlichen bzw. korrigierten Batteriekapazität ist auch eine genaue Aussage über die tatsächlich verfügbare Strommenge einer Batterie möglich.

Zur Berechnung der aufgenommenen Ladestrommenge kann in vorteilhafter Weise eine Entladestrommenge und die zugeführte Ladestrommenge getrennt kumuliert, ein Ladefaktor als Quotient von zugeführter Ladestrommenge/Entladestrommenge gebildet und die zugeführte Ladestrommenge durch den Ladefaktor dividiert werden.

Gemäß einer weiteren vorteilhaften Weiterbildung der Erfindung erfolgt bei dem erfindungsgemäßen Verfahren die Feststellung der tatsächlichen Kapazität der Batterie, indem die Schritte gemäß Anspruch 1 mehrere Male in Folge wiederholt und eine Bewertung der ermittelten Differenz zwischen der Schlussspannung (UL_{Mess}, UE_{Mess}) und der erwarteten Spannung (UL_{Erwartet}, UE_{Erwartet}) durchgeführt werden.

Ebenso ist es vorteilhaft, wenn beim erfindungsgemäßen Verfahren die Feststellung der tatsächlichen Kapazität der Batterie erfolgt, nachdem die Schritte gemäß Anspruch 1 wenigstens 5 Mal in Folge durchgeführt wurden.

Zur Feststellung der tatsächlichen Kapazität kann vorteilhafter Weise beispielsweise wie folgt vorgegangen werden: in einem zweidimensionalen Koordinatensystem werden die Anfangsspannung (UL_{Beginn}, UE_{Beginn}) und die Schlussspannung (UL_{Mess}, UE_{Mess}) der Batterie gegen die Zeit in Abhängigkeit von der aufgenommenen bzw. entnommenen Ladungsmenge, sowie die erwartete Spannung (UL_{Erwartet}, UE_{Erwartet}) gegen die Zeit in Abhängigkeit von der aufgenommenen bzw. entnommenen Ladungsmenge eingetragen, werden die Steigung der Verbindungslinie zwischen der Anfangsspannung (UL_{Beginn}, UE_{Beginn}) und der Schlussspannung (UL_{Mess}, UE_{Mess}), sowie die Steigung der Verbindungslinie zwischen der Anfangsspannung (UL_{Beginn}, UE_{Beginn}) und der erwarteten Spannung (UL_{Erwartet}, UE_{Erwartet}) ermittelt, und wird die Differenz der Steigungen der Verbindungslinien oder der Winkel zwischen den Verbindungslinien (ϕ) ermittelt. Diese ermittelten Werte können dann zur Feststellung der tatsächlichen Kapazität herangezogen werden.

Da die Feststellung einer verringerten tatsächlichen Kapazität einer Batterie zum Beispiel für das Energiemanagement eines Elektrofahrzeugs oder Hybrid-Fahrzeugs von eminenter Wichtigkeit ist, und die tatsächliche Kapazität beispielsweise für eine Reichweitenvoraussage verwendet wird, ist es gemäß einer weiteren vorteilhaften Weiterbildung der Erfindung vorgesehen, dass für den Fall, dass die Bewertung des Alterungszustands eine im Vergleich zu einer neuwertigen Batterie verringerte tatsächliche Kapazität ergeben hat, eine verringerte nominale, entnehmbare, verfügbare und/oder tatsächliche Kapazität in einer Speichereinrichtung gespeichert wird/werden.

Diese(r) gespeicherte(n) Wert(e) stehen dann beispielsweise anderen Einrichtungen für weitere Berechnungen und/oder Bewertungen zur Verfügung und können beispielsweise aus der Speichereinrichtung ausgelesen werden.

Für den Fall, dass die Bewertung des Alterungszustands eine im Vergleich zu einer neuwertigen Batterie verringerte tatsächliche Kapazität ergeben hat, wird/werden in vorteilhafter Weise bei einem durch eine mathematische Formel beschriebenen Kennlinienfeld und/oder bei einer durch eine mathematische Formel beschriebenen Kennlinie die Größe der nominalen, entnehmbaren und/oder verfügbaren Kapazität um ein vorgebbaren Wert zurückgenommen.

Aus Gründen der Systemstabilität ist es von Vorteil, wenn die ermittelte Änderung der tatsächlichen Kapazität nicht voll angerechnet wird, sondern nur eine Adaption in die entsprechende Änderungsrichtung beschrieben wird. Daher ist vorteilhaft, wenn die ermittelte Verringerung der tatsächlichen Kapazität nicht im vollem Umfang für die Bestimmung der nominalen, entnehmbaren und/öder verfügbaren Kapazität verwendet wird.

Die vorliegende Erfindung umfasst auch eine Vorrichtung zum Feststellen der tatsächlichen Kapazität einer Batterie mit einer Speichereinrichtung, einer Spannungsmesseinrichtung, einer Strommesseinrichtung, einer Temperaturmesseinrichtung und einer Recheneinheit und einem darin ausführbaren Computerprogramm, wobei die Speichereinrichtung dazu eingerichtet ist, wenigstens ein Kennlinienfeld einer Batterie zu speichern bzw. darin gespeichert zu haben, die Spannungsmesseinrichtung dazu eingerichtet ist, wenigstens eine Anfangsspannung (UL_{Beginn}, UE_{Beginn}) der Batterie am Anfang und eine Schlussspannung (UL_{Mess}, UE_{Mess}) der Batterie am Ende eines Lade- und eines Entladevorgangs zu messen, die Strommesseinrichtung dazu eingerichtet ist, die Stärke eines Lade- und Entladestroms der Batterie zu messen, die Temperaturmesseinrichtung dazu eingerichtet ist, die Temperatur von wenigstens einer Batteriekomponente zu messen, und die Recheneinheit mit dem darauf ablaufenden Computerprogramm dazu eingerichtet ist, unter Berücksichtigung der Anfangsspannung (UL_{Beginn}, UE_{Beginn}), der Schlussspannung (UL_{Mess}, UE_{Mess}), der aufgrund der gewählten Kennlinie erwarteten Spannung (UL_{Erwartet}, UE_{Erwartet}) und gegebenenfalls unter Berücksichtigung der aufgenommenen Ladestrommenge die tatsächliche Kapazität der Batterie festzustellen, derart, dass für den Fall, dass die Schlussspannung (UL_{Mess}) größer als die aufgrund der gewählten Kennlinie erwarteten Spannung (UL_{Erwartet}) am Ende des Ladevorgangs ist, und die Schlussspannung (UE_{Mess}) kleiner als die aufgrund der gewählten Kennlinie erwartete Spannung (UE_{Erwartet}) am Ende des Entladevorgangs ist, festgestellt wird, dass die tatsächliche Kapazität der Batterie kleiner ist als die am Anfange des Lade- und Entladevorgangs angenommene entnehmbare Kapazität, und die Ergebnisse des Ladevorgangs und die Ergebnisse des Entladevorgangs gleichgewichtig für die Feststellung der tatsächlichen Kapazität der Batterie berücksichtigt werden.

Die erfindungsgemäße Vorrichtung ist weiter dazu eingerichtet, ein jedes der oben beschriebenen Verfahren durchführen zu können. Eine Ausgestaltung der erfindungsgemäßen Vorrichtung derart, dass sie zur Durchführung aller erfindungsgemäßen Verfahren geeignet ist, ist Fachleuten aufgrund ihrer Kenntnisse bekannt bzw. kann durch einige wenige Versuche leicht ermittelt werden.

Die vorliegende Erfindung wird anhand der beigefügten Zeichnungen näher erläutert.

Dabei zeigen:
- Fig. 1: Ein Diagramm mit einem typischen Spannungsverlauf bei einer Abfolge von Lade- und Entladevorgängen einer Batterie und drei Messvorgänge.
- Fig. 2:: Ein Diagramm mit einigen für einen Entladevorgang in einem Kennfeld einer Batterie hinterlegten Kennlinien;
- Fig. 3:: Ein Diagramm mit dem tatsächlichen Verlauf der Spannung einer Batterie aufgetragen gegen die Zeit in Abhängigkeit von der entnommenen Ladungsmenge und dem entsprechenden erwarteten Verlauf der Spannung aufgrund der ausgewählten Kennlinie;
- Fig. 4:: Ein ähnliches Diagramm wie in Fig. 3, jedoch mit eingetragenen Verbindungsgeraden zwischen UE_{Beginn} und UE_{Mess} sowie UE_{Beginn} und UE_{Erwartet}.

Die Darstellungen in den Figuren sind rein schematisch und nicht maßstabesgerecht.

Die nachfolgend erläuterten Ausführungsbeispiele stellen bevorzugte Ausführungsformen der vorliegenden Erfindung dar. Die vorliegende Erfindung ist selbstverständlich nicht auf diese Ausführungsformen beschränkt.

In der nachfolgenden Beschreibung haben die folgenden Begriffe die jeweils angegebene Bedeutung:
- Nominale Kapazität:: Die gemäß Angabe des Herstellers entnehmbare Strommenge, normiert auf eine Standard-Temperatur und einen Referenzstrom (wird auch als Nennkapazität bezeichnet);
- Entnehmbare Kapazität:: die je nach Batterie-/AkkumulatorTechnologie unterschiedlich große, tatsächlich entnehmbare Strommenge in Abhängigkeit von der Temperatur und der Stromstärke;
- Verfügbare Kapazität:: gemessene Kapazität bei StandardTemperatur und Referenzstromstärke; wird zur Bewertung der Abweichung von der nominalen Kapazität verwendet;
- Tatsächliche Kapazität:: tatsächlich entnehmbare Kapazität in Abhängigkeit von der Temperatur und der Stromstärke;
- aufgenommene Strommenge:: Strommenge, die eine Batterie bei einem Ladevorgang tatsächlich speichert;
- zugeführte Strommenge:: Strommenge, die einer Batterie bei einem Ladevorgang zugeführt wird.

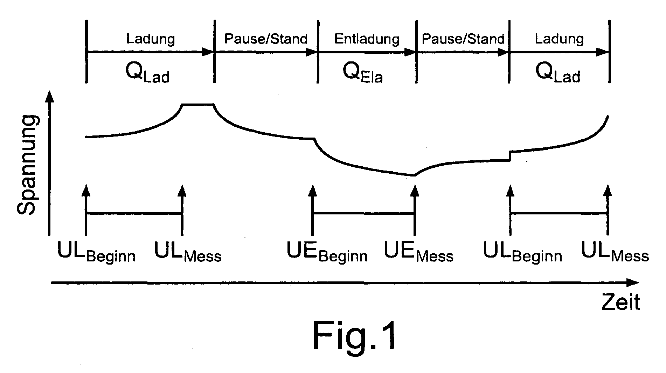

Fig. 1 zeigt ein Diagramm mit einem typischen Spannungsverlauf bei einer Abfolge von Lade- und Entladevorgängen einer Batterie und drei Messvorgänge, wovon zwei Messvorgänge während eines Ladevorgangs und ein Messvorgang während eines Entladevorgangs vorgenommen werden. Aus den jeweils ermittelten Messwerten kann unter Zuhilfenahme des erfindungsgemäßen Verfahrens der Alterungszustand der Batterie ermittelt werden.

Bei dem erfindungsgemäßen Verfahren können zur Bestimmung des Alterungszustands eine Kombination aus ein oder mehreren Ladevorgängen und ein oder mehreren Entladevorgängen betrachtet werden.

In der Praxis tritt häufig der Fall ein, dass bei Elektroantrieben die Entladungsvorgänge eher zerstückelt auftreten, die Ladungsvorgänge aber eher unterbrechungsfrei, beispielsweise wenn die Batterie eines Elektrofahrzeugs über mehrere Stunden aufgeladen wird. Für das erfindungsgemäße Verfahren ist jedoch keine längere, möglicherweise ununterbrochene Ladephase, beispielsweise bis zur Volladung der Batterie erforderlich.

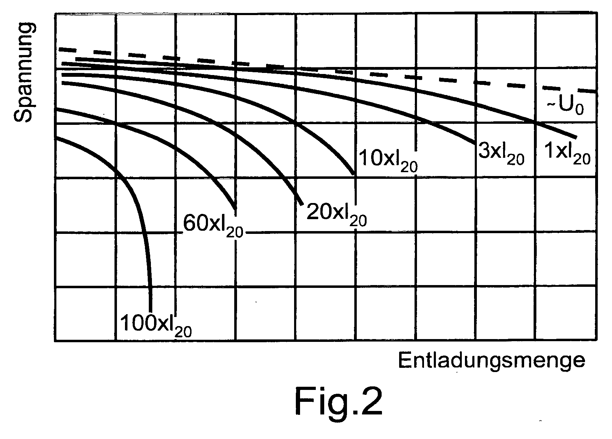

Das in Fig. 2 gezeigte Diagramm zeigt Spannungsverläufe einer Batterie am Beispiel einer Entladung mit verschiedenen Stromstärken bei einer gegebenen Temperatur sowie den ungefähren Verlauf der Ruhespannung U₀.

Der im Diagramm angegebene I₂₀ bedeutet einen 20-stündigen Entladestrom bezogen auf die nominale Kapazität. Wie aus dem Diagramm ersichtlich ist, sinkt mit steigender Stromstärke (=steigendes Vielfaches von I₂₀) die Anfangsspannung (Spannungslage) der Batterie. Gleichzeitig sinkt bei höherer Stromstärke die entnehmbare Strommenge. Eine weitere Abhängigkeit besteht in Bezug auf die Temperatur der Batterie. Hier gilt vereinfacht, dass die Entlademengen geringer und die Batteriespannung niedriger werden, je niedriger die Temperatur ist.

Mit Hilfe dieses Wissens oder durch Messungen kann ein Kennlinienfeld generiert oder erzeugt werden, wobei die einzelnen Kennlinien unter Berücksichtigung der Entladestromstärke, der Temperatur und der entnehmbaren Kapazität der Batterie generiert oder erzeugt werden.

Auf Grundlage des Kennlinienfelds kann unter Betrachtung der Entladestromstärke und der Temperatur der Batteriezustand beurteilt werden. Es kann der aktuelle Zustand der Batterie bewertet werden, es kann eine Abschätzung der entnehmbaren Ladungsmenge und mittels eines Vergleichs des tatsächlichen Spannungsverlaufs mit dem aufgrund der gewählten Kennlinie erwarteten Spannungsverlauf unter Berücksichtigung der tatsächlich entnommenen Ladungsmenge der Alterungszustand der Batterie bewertet werden.

Auf ähnliche Weise kann ein Kennlinienfeld für Ladevorgänge generiert oder erzeugt, und eine Bewertung des Alterungszustands einer Batterie durch Messungen in der Ladephase durch das erfindungsgemäße Verfahren erfolgen. Bei einer spannungsbegrenzten Ladung kann dann die Änderung des Ladestroms in Abhängigkeit von der Ladespannung und der Temperatur als Bewertungskriterium herangezogen werden. Bei Bewertung des Alterungszustands einer Batterie mit Hilfe von Messungen bei Ladevorgängen ist üblicherweise ein Energieverlust zu berücksichtigen (Ladefaktor oder Wirkungsgrad).

Weder bei einer Bewertung des Alterungszustands einer Batterie durch Messungen bei einem Ladevorgang noch bei einer Bewertung des Alterungszustands einer Batterie durch Messungen bei einem Entladevorgang ist erfindungsgemäß eine Bewertung eines Ruhezustandes der Batterie erforderlich.

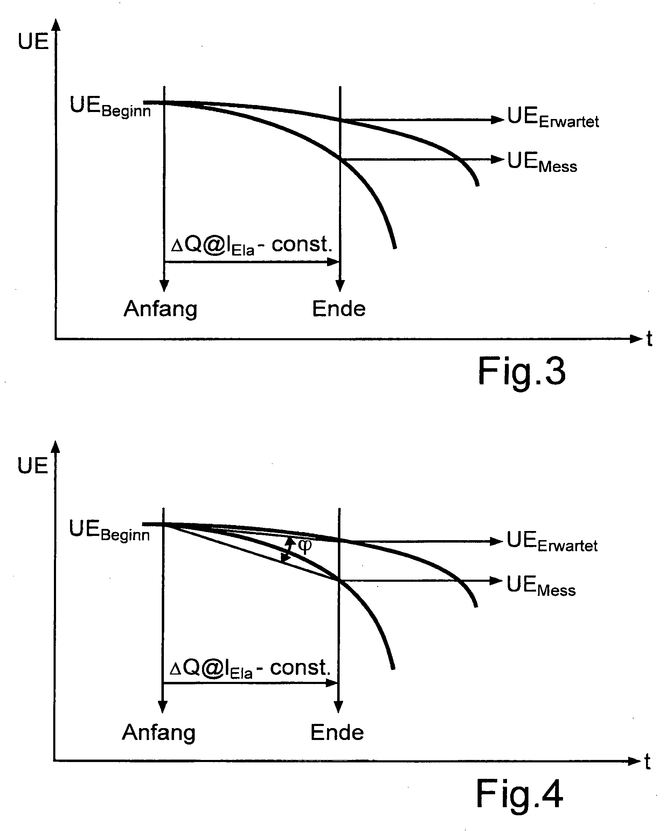

Fig. 3 und Fig. 4 zeigen (wieder am Beispiel eines Entladevorgangs) jeweils ein Diagramm, in dem der tatsächliche Verlauf der Spannung UE einer Batterie aufgetragen gegen die Zeit t in Abhängigkeit von der entnommenen Ladungsmenge ΔQ_{EIa} und der erwartete entsprechende Verlauf der Spannung aufgrund der ausgewählten Kennlinie gezeigt sind. Wie aus den Diagrammen zu entnehmen ist, wird hierbei im Verlauf der Zeit t von einer im Wesentlichen konstanten Stromstärke I_{EIa} ausgegangen.

Die zu wählende Kennlinie wird erfindungsgemäß aufgrund der Anfangsspannung UE_{Beginn} der Batterie, der Entladestromstärke und der Temperatur der Batterie aus dem Kennlinienfeld ausgewählt.

Am Ende des Entladevorgangs wird die Schlussspannung UE_{Mess} der Batterie gemessen, und diese Schlussspannung UE_{Mess} wird mit der aufgrund der gewählten Kennlinie erwarteten Spannung UE_{Erwartet} am Ende der Entladung verglichen. Für den in den Fig. 3 und 4 dargestellten Fall, dass die Schlussspannung UE_{Mess} kleiner als die erwartete Spannung UE_{Erwartet} am Ende des Entladevorgangs ist, wird festgestellt, dass die tatsächliche Kapazität der Batterie kleiner ist als die am Anfang des Entladevorgangs angenommene entnehmbare Kapazität.

Für die Berechnung der tatsächlichen Kapazität bzw. für die Berechnung der Verringerung der tatsächlichen Kapazität im Vergleich zur nominalen, entnehmbaren und/oder verfügbaren Kapazität kann auf bekannte Erfahrungswerte bzw. Berechnungsmethoden zurückgegriffen werden.

Wie in den Fig. 3 und 4 gezeigt, kann in einem zweidimensionalen Koordinatensystem, dem bei Verwendung einer Recheneinheit ein zweidimensionales Datenarray entspricht, die Anfangsspannung UE_{Beginn} und die Schlussspannung UE_{Mess} der Batterie gegen die Zeit in Abhängigkeit von der entnommenen Ladungsmenge, sowie die erwartete Spannung UE_{Erwartet} gegen die Zeit in Abhängigkeit von der entnommenen Ladungsmenge eingetragen werden.

Da bei dem erfindungsgemäßen Verfahren zur Beurteilung des Alterungszustands einer Batterie auch Entladevorgänge berücksichtigt werden, wird hierbei am Anfang eines Entladevorgangs die Anfangsspannung UE_{Beginn} gemessen. Da diese Anfangsspannung u.a. von der Stärke des Entladestroms abhängig ist, ist "am Anfang" hier so zu verstehen, dass gegebenenfalls eine ausreichende Zeitdauer am Beginn des Entladevorgangs abgewartet werden kann (z.B. 1, 2, 4, 6, 8, 10, 15, 30 Sekunden; 1, 2, 3, 4, 5 Minuten), bis sich eine "stabile" Anfangsspannung eingestellt hat. Wie Fachleuten bekannt ist, hängt die Zeitdauer, bis zu der sich eine "stabile" Anfangsspannung einstellt, derart von der Entlade-Stromstärke ab, dass bei niedrigen Stromstärken (z.B. im Bereich von etwa 1xI₂₀ bis zu etwa 5x I₂₀) eine Zeitdauer im Minutenbereich, und bei hohen Stromstärken (z.B. im Bereich ab etwa 10xI₂₀) eine Zeitdauer von weniger als einer Minute ausreichend ist.

Selbstverständlich kann auch zur Messung einer Anfangsspannung bei einem Ladevorgang gegebenenfalls eine erforderliche Zeitdauer abgewartet werden, bis sich eine "stabile" Anfangsspannung eingestellt hat.

Da während eines Lade- oder Entladevorgangs in der Regel nicht bekannt ist, wann dieser endet, kann selbstverständlich die Spannung und Strom der Batterie während eines Lade- oder Entladevorgangs kontinuierlich oder in vorgebbaren Zeitabständen gemessen werden. Wenn dann der Lade- oder Entladevorgang beendet ist, kann die zuletzt während des Lade- oder Entladevorgangs gemessene Spannung als Schlussspannung (UL_{Mess}, UE_{Mess}) beim entsprechend gemessenen Strom verwendet werden.

Wie in Fig. 3 und 4 am Beispiel eines Entladevorgangs dargestellt, kann die ermittelte Differenz zwischen UE_{Mess} und UE_{Erwartet} unter Berücksichtigung der verwendeten Kennlinie zur Bewertung des Alterungszustands einer Batterie verwendet werden.

Beispielsweise kann, wie dies in Fig. 4 dargestellt ist, die Steigung der Verbindungslinie zwischen der Anfangsspannung UE_{Beginn} und der Schlussspannung UE_{Mess}, sowie die Steigung der Verbindungslinie zwischen der Anfangsspannung UE_{Beginn} und der erwarteten Spannung UE_{Erwartet} ermittelt werden, die Differenz der Steigungen der Verbindungslinien oder der Winkel ϕ zwischen den Verbindungslinien ermittelt und zur Bewertung des Alterungszustands der Batterie und/oder zur Feststellung der tatsächlichen Kapazität verwendet werden.

Überschreitet beispielsweise der in Fig. 4 gezeigte Winkel ϕ einen vorgebbaren Schwellwert, kann durch die Alterungsbewertung die entnehmbare Kapazität um einen bestimmten Betrag zurückgenommen, bzw. die Berechnung der verfügbaren Kapazität auf Basis einer "kleineren" Batterie durchgeführt werden.

Auf entsprechende Weise kann eine Beurteilung des Alterungszustands einer Batterie aufgrund von Messungen während eines Ladevorgangs vorgenommen werden.

Erfahrungsgemäß sollte eine Bewertung des Alterungszustands und/oder die Feststellung der tatsächlichen Kapazität einer Batterie nicht nur auf einer Einzelmessung beruhen, sondern es sollte die Messung mehrere Male, bevorzugt mindestens 5 Mal oder öfter (z.B. 6, 7, 8, 9, 10, 12, 14, 15) in Folge wiederholt werden und eine Bewertung der Abweichung UL_{Erwartet} - UL_{Mess} und UE_{Erwartet} - UE_{Mess} oder des jeweiligen Winkels ϕ vorgenommen werden. Hintergrund hierfür ist, dass die zu bestimmenden Größen durch viele Parameter beeinflusst werden können, und durch eine ausreichende Anzahl an Wiederholungen und entsprechende Bewertung der ermittelten Messergebnisse (z.B. Mittelwertbildung) eine ausreichend genaue Annäherung an den tatsächlich gegebenen Alterungszustand der Batterie erreicht werden kann.

Allgemein gilt, dass mit einer steigenden Anzahl an Messungen auch die Genauigkeit bei der Beurteilung des Alterungszustands der Batterie zunimmt.

Erfindungsgemäß wird eine Kombination aus Messungen bei Ladevorgängen und Messungen bei Entladevorgängen berücksichtigt. Es muss kein bestimmtes Verhältnis zwischen Messungen bei Ladevorgängen und Messungen bei Entladevorgängen eingehalten werden und die Ergebnisse von Messungen bei Ladevorgängen und Messungen bei Entladevorgängen werden ohne unterschiedliche Gewichtung in der Gesamtbeurteilung des Alterungszustands der Batterie berücksichtigt.

Aus Gründen der Systemstabilität ist es oftmals auch von Vorteil, wenn die festgestellte Verringerung der tatsächlichen Kapazität nicht im vollen Umfang in die Berechnung der nominalen, entnehmbaren und/oder verfügbaren Kapazität eingeht, sondern lediglich eine Adaption in die entsprechende Änderungsrichtung vorgenommen wird. So kann beispielsweise die ermittelte Verringerung der tatsächlichen Kapazität mit einem vorgebbaren Faktor <1 (z.B. 0,9; 0,8; 0,75; 0,6; 0,5) multipliziert und der sich so ergebende Bruchteil der ermittelten Verringerung der tatsächlichen Kapazität für die Bewertung bzw. Berechnung verwendet werden.

Ist das verwendete Kennlinienfeld bzw. die verwendete Kennlinie durch eine mathematische Formel beschrieben, so kann beispielsweise die Größe der nominalen, entnehmbaren und/oder verfügbaren Kapazität um ein definiertes Delta zurückgenommen werden.

Die Alterung und damit die Änderung der verfügbaren Kapazität einer Batterie ist keine stochastisch einsetzende sondern eine sich langsam ändernde Größe. Vor diesem Hintergrund können die erfindungsgemäßen Verfahren beispielsweise kontinuierlich, in vorgebbaren Zeitabständen und/oder nach eine vorgebbaren Anzahl an Lade- und Entladevorgängen wiederholt werden.

Das erfindungsgemäße Verfahren ist bei normalen Einsatzzwecken verwendbar, ist einfach anzuwenden, benötigt keine speziellen Testmodi oder -prozeduren, und beruht nicht auf komplizierten Parametern und/oder Modellen. Durch das erfindungsgemäße Verfahren kann somit im laufenden Betrieb auf einfache Weise eine dedizierte Aussage über den aktuellen Energieinhalt einer Batterie gemacht werden. Aufgrund der durch das erfindungsgemäße Verfahren richtig nachgeführten tatsächlichen bzw. korrigierten Batteriekapazität ist auch eine genaue Aussage über die tatsächlich verfügbare Strommenge einer Batterie möglich. Das erfindungsgemäße Verfahren hat weiter den Vorteil, dass es unabhängig von der Zelltechnologie anwendbar ist und keine Ah-Integration erfordert.

## Patentansprüche

1. Verfahren zum Feststellen der tatsächlichen Kapazität einer Batterie unter Verwendung eines Kennlinienfelds, wobei
am Anfang eines Ladevorgangs die Anfangsspannung (UL_{Beginn}) der Batterie, die Ladestromstärke und die Temperatur der Batterie ermittelt werden, hieraus durch Vergleich mit den im Kennlinienfeld vorhandenen Daten eine Kennlinie ausgewählt und ein Anfangszustand der Batterie festgelegt werden,
am Ende des Ladevorgangs die Schlussspannung (UL_{Mess}) und der Ladestrom der Batterie gemessen wird,
die Schlussspannung (UL_{Mess}) mit der aufgrund der gewählten Kennlinie und unter Berücksichtigung der aufgenommenen Ladestrommenge erwarteten Spannung (UL_{Erwartet}) am Ende der Ladung verglichen wird und
für den Fall, dass die Schlussspannung (UL_{Mess}) größer als die aufgrund der gewählten Kennlinie erwartete Spannung (UL_{Erwartet}) am Ende des Ladevorgangs ist, festgestellt wird, dass die tatsächliche Kapazität der Batterie kleiner ist als die am Anfang des Ladevorgangs angenommene entnehmbare Kapazität,
am Anfang eines Entladevorgangs die Anfangsspannung (UE_{Beginn}) der Batterie, die Entladestromstärke und die Temperatur der Batterie ermittelt werden, hieraus durch Vergleich mit den im Kennlinienfeld vorhandenen Daten eine Kennlinie ausgewählt und ein Anfangszustand der Batterie festgelegt werden,
am Ende des Entladevorgangs die Schlussspannung (UE_{Mess}) der Batterie gemessen wird,
die Schlussspannung (UE_{Mess}) mit der aufgrund der gewählten Kennlinie erwarteten Spannung (UE_{Erwartet}) am Ende der Entladung verglichen wird und für den Fall, dass die Schlussspannung (UE_{Mess}) kleiner als die aufgrund der gewählten Kennlinie erwartete Spannung (UE_{Erwartet}) am Ende des Entladevorgangs ist, festgestellt wird, dass die tatsächliche Kapazität der Batterie kleiner ist als die am Anfang des Entladevorgangs angenommene entnehmbare Kapazität, und
die Ergebnisse des Ladevorgangs und die Ergebnisse des Entladevorgangs gleichgewichtig für die Feststellung der tatsächlichen Kapazität der Batterie berücksichtigt werden.

2. Verfahren nach Anspruch 1, wobei
zur Berechnung der aufgenommenen Ladestrommenge eine Entladestrommenge und die zugeführte Ladestrommenge getrennt kumuliert, ein Ladefaktor als Quotient von zugeführter Ladestrommenge/Entladestrommenge gebildet und die zugeführte Ladestrommenge durch den Ladefaktor dividiert wird.

3. Verfahren nach einem der vorhergehenden Ansprüche, wobei
die Feststellung der tatsächlichen Kapazität der Batterie erfolgt, indem die Schritte gemäß Anspruch 1 mehrere Male in Folge wiederholt und eine Bewertung der ermittelten Differenz zwischen der Schlussspannung (ULₘₑₛₛ, UE_{Mess}) und der erwarteten Spannung (UL_{Erwartet}, UE_{Erwartet}) durchgeführt werden.

4. Verfahren nach Anspruch 3, wobei
die Feststellung der tatsächlichen Kapazität der Batterie erfolgt, nachdem die Schritte gemäß Anspruch 1 wenigstens 5 Mal in Folge durchgeführt wurden.

5. Verfahren nach einem der vorhergehenden Ansprüche, wobei
in einem zweidimensionalen Koordinatensystem die Anfangsspannung (UL_{Beginn}, UE_{Beginn}) und die Schlussspannung (UL_{Mess}, UE_{Mess}) der Batterie gegen die Zeit in Abhängigkeit von der aufgenommenen bzw. entnommenen Ladungsmenge, sowie die erwartete Spannung (UL_{Erwartet}, UE_{Erwartet}) gegen die Zeit in Abhängigkeit von der aufgenommenen bzw. entnommenen Ladungsmenge eingetragen werden, die Steigung der Verbindungslinie zwischen der Anfangsspannung (UL_{Beginn}, UE_{Beginn}) und der Schlussspannung (UL_{Mess}, UE_{Mess}), sowie die Steigung der Verbindungslinie zwischen der Anfangsspannung (UL_{Beginn}, UE_{Beginn}) und der erwarteten Spannung (UL_{Erwartet}, UE_{Erwartet}) ermittelt werden, die Differenz der Steigungen der Verbindungslinien oder der Winkel zwischen den Verbindungslinien (ϕ) ermittelt und zur Feststellung der nominalen, entnehmbaren, verfügbaren und/oder tatsächlichen Kapazität verwendet werden.

6. Verfahren nach einem der vorhergehenden Ansprüche, wobei
für den Fall, dass die Feststellung der tatsächlichen Kapazität eine im Vergleich zu einer neuwertigen Batterie verringerte tatsächliche Kapazität ergeben hat, eine verringerte nominale, entnehmbare, verfügbare und/oder tatsächliche Kapazität in einer Speichereinrichtung gespeichert wird/werden.

7. Verfahren nach einem der vorhergehenden Ansprüche, wobei
für den Fall, dass die Feststellung der tatsächlichen Kapazität eine im Vergleich zu einer neuwertigen Batterie verringerte tatsächliche Kapazität ergeben hat, bei einem durch eine mathematische Formel beschriebenen Kennlinienfeld oder einer durch eine mathematische Formel beschriebenen Kennlinie die Größe der nominalen, entnehmbaren und/oder verfügbaren Kapazität um ein vorgebbaren Wert zurückgenommen wird.

8. Verfahren nach einem der Ansprüche 6 oder 7, wobei
die ermittelte Verringerung der tatsächlichen Kapazität nicht im vollen Umfang für die Bewertung der nominalen, entnehmbaren und/oder verfügbaren Kapazität verwendet wird.

9. Vorrichtung zum Feststellen der tatsächlichen Kapazität einer Batterie mit einer Speichereinrichtung, einer Spannungsmesseinrichtung, einer Strommesseinrichtung, einer Temperaturmesseinrichtung und einer Recheneinheit und einem darin ausführbaren Computerprogramm, wobei
die Speichereinrichtung dazu eingerichtet ist, wenigstens ein Kennlinienfeld einer Batterie zu speichern bzw. darin gespeichert zu haben,
die Spannungsmesseinrichtung dazu eingerichtet ist, wenigstens eine Anfangsspannung (UL_{Beginn}, UE_{Beginn}) der Batterie am Anfang und eine Schlussspannung (UL_{Mess}, UE_{Mess}) der Batterie am Ende eines Lade- und eines Entladevorgangs zu messen,
die Strommesseinrichtung dazu eingerichtet ist, die Stärke eines Lade- und Entladestroms der Batterie zu messen,
die Temperaturmesseinrichtung dazu eingerichtet ist, die Temperatur von wenigstens einer Batteriekomponente zu messen, und
die Recheneinheit mit dem darauf ablaufenden Computerprogramm dazu eingerichtet ist, unter Berücksichtigung der Anfangsspannung (UL_{Beginn}, UE_{Beginn}), der Schlussspannung (UL_{Mess}, UE_{Mess}), der aufgrund der gewählten Kennlinie erwarteten Spannung (UL_{Erwartet}, UE_{Erwartet}) und gegebenenfalls unter Berücksichtigung der aufgenommenen Ladestrommenge die tatsächliche Kapazität der Batterie festzustellen, derart, dass
für den Fall, dass die Schlussspannung (UL_{Mess}) größer als die aufgrund der gewählten Kennlinie erwartete Spannung (UL_{Erwartet}) am Ende des Ladevorgangs ist, und die Schlussspannung (UE_{Mess}) kleiner als die aufgrund der gewählten Kennlinie erwartete Spannung (UE_{Erwartet}) am Ende des Entladevorgangs ist, festgestellt wird, dass die tatsächliche Kapazität der Batterie kleiner ist als die am Anfang des Lade- und Entladevorgangs angenommene entnehmbare Kapazität und die Ergebnisse des Ladevorgangs und die Ergebnisse des Entladevorgangs gleichgewichtig für die Feststellung der tatsächlichen Kapazität der Batterie berücksichtigt werden.

10. Vorrichtung nach Anspruch 9, die eingerichtet ist, eines der Verfahren gemäß den Ansprüchen 2 bis 8 durchzuführen.

## Claims

1. A method for detecting an actual capacity of a battery using a characteristic curve field, the method comprising the steps of:
determining at the beginning of a charging process an initial voltage (UL_{Beginn}) of the battery, a charging rate and a temperature of the battery,
by comparison of the charging rate and the temperature with data contained in the characteristic curve field, selecting a characteristic curve and determining an initial state of the battery,
measuring at the end of the charging process a final voltage (UL_{Mess}) and the charging current of the battery,
comparing the final voltage (UL_{Mess}) with an expected voltage (UL_{Erwartet}) expected at the end of the charging process based on the selected characteristic curve and taking into consideration the magnitude of charging current input, and
when the final voltage (UL_{Mess}) is greater than the expected voltage (UL_{Erwartet}) expected at the end of the charging process based on the selected characteristic curve, concluding that the actual capacity of the battery is smaller than the removable capacity assumed at the beginning of the charging process,
determining at the beginning of a discharge process the initial voltage (UE_{Beginn}) of the battery, a discharge rate and a temperature of the battery,
by comparison of the discharge rate and temperature with data.contained in the characteristic curve field, selecting a characteristic curve and determining the initial state of the battery,
measuring at the end of the discharge process the final voltage (UE_{Mess}) of the battery,
comparing the final voltage (UE_{Mess}) with an expected voltage (UE_{Erwartet}) expected at the end of the discharge process based on the selected characteristic curve, and
when the final voltage (UE_{Mess}) is smaller than the expected voltage (UE_{Erwartet}) expected at the end of the discharge process based on the selected characteristic curve, concluding that the actual capacity of the battery is smaller than the removable capacity assumed at the beginning of the discharge process, and
taking equally into account the results of the charging process and the results of the discharge process for determining the actual capacity of the battery.

2. The method according to claim 1, wherein
the magnitude of discharge current and the magnitude of charging current supplied are cumulated separately, a charging factor is calculated as a quotient of the magnitude of charging current/ discharge current supplied and the magnitude of charging current supplied is divided by the charging factor to determine the magnitude of charging current input.

3. The method according to any of the preceding claims, wherein
the actual capacity of the battery is determined by repeating the steps of claim 1 several times and assessing the calculated difference between the final voltage (UL_{Mess}, UE_{Mess}) and the expected voltage (UL_{Erwartet}, UE_{Erwartet}).

4. The method according to claim 3, wherein
the actual capacity of the battery is determined by repeating the steps of claim 1 at least five times.

5. The method according to any of the preceding claims, comprising:
entering the initial voltage (UL_{Beginn}, UE_{Beginn}) and the final voltage (UL_{Mess}, UE_{Mess}) of the battery as a function of time and based on the received and removed amount of current charge, respectively, into a two-dimensional coordinate system, entering the expected voltage (UL_{Erwartet}, UE_{Erwartet}) as a function of time and based on the received and removed amount of current charge, respectively, into a two-dimensional coordinate system, determining the slope of the connecting line between the initial voltage (UL_{Beginn}, UE_{Beginn}) and the final voltage (UL_{Mess}, UE_{Mess}), and the slope of the connecting line between the initial voltage (UL_{Beginn}, UE_{Beginn}) and the expected voltage (UL_{Erwartet}, UE_{Erwartet}), determining the difference of the slopes of the connecting lines or the angle between the connecting lines (ϕ), for determining the nominal, removable, available and/or actual capacity.

6. The method according to any of the preceding claims, wherein when the determined actual capacity is smaller than an actual capacity of a new battery, a reduced nominal, removable, available and/or actual capacity is stored in a memory device.

7. The method according to any of the preceding claims, wherein when the determined actual capacity is smaller than an actual capacity of a new battery, the nominal, removable and/or available capacity is reduced by a specifiable value when the characteristic curve field or the characteristic curve is described by a mathematical formula.

8. The method according to any of claims 6 or 7, wherein the nominal, removable and/or available capacity is reduced by less than the full specifiable value.

9. A device for detecting the actual capacity of a battery, the device comprising a memory device, a voltage measuring device, a current measuring device, a temperature measuring device, and a computing device having a computer program executable thereon, wherein
the memory device is configured to store, or have stored therein, at least one characteristic curve field of the battery,
the voltage measuring device is configured to measure at least one initial voltage (UL_{Beginn}, UE_{Beginn}) of the battery at the beginning of a charging and discharge process, and to measure a final voltage (UL_{Mess}, UE_{Mess}) of the battery at the end of a charging and discharge process,
the current measuring device is configured to measure a magnitude of a charging and discharge current of the battery,
the temperature measuring device is configured to measure a temperature of at least one battery component, and
the computing device with the computer program being executed thereon is configured to determine the actual capacity of the battery, based on the initial voltage (UL_{Beginn}, UE_{Beginn}), the final voltage (UL_{Mess}, UE_{Mess}), the expected voltage (UL_{Erwartet}, UE_{Erwartet}) expected based on the selected characteristic curve and, if - appropriate, the magnitude of charging current input, such that
when the final voltage (UL_{Mess}) is greater than the expected voltage (UL_{Erwartet}) expected at the end of the charging process based on the selected characteristic curve, and the final voltage (UE_{Mess}) is smaller than the expected voltage (UE_{Erwartet}) expected at the end of the discharge process based on the selected characteristic curve, it is concluded that the actual capacity of the battery is smaller than the removable capacity assumed at the beginning of the charging and discharge process and the results of the charging process and the results of the discharge process are equally taken into consideration for determining the actual capacity of the battery.

10. The device according to claim 9, configured to carry out a method according to any of claims 2 to 8.

## Revendications

1. Procédé de détermination de la capacité réelle d'une batterie en utilisant un réseau de caractéristiques,
selon lequel, au début d'une opération de charge, on détermine la tension initiale (UL_{Beginn}) de la batterie, l'intensité de courant de charge et la température de la batterie,
selon lequel, à partir de là, en comparant avec les données présentes dans le réseau de caractéristiques, on choisit une courbe caractéristique et on fixe un état initial de la batterie,
selon lequel, à la fin de l'opération de charge, on mesure la tension finale (UL_{Mess}) et le courant de charge de la batterie,
selon lequel on compare la tension finale (UL_{Mess}) à la tension (UL_{Erwartet}), escomptée d'après la courbe caractéristique choisie et en tenant compte de la quantité de courant de charge reçue, à la fin de la charge et
selon lequel, si la tension finale (UL_{Mess}) est supérieure à la tension (UL_{Erwartet}), escomptée d'après la courbe caractéristique choisie, à la fin de l'opération de charge, on détermine que la capacité réelle de la batterie est inférieure à la capacité supposée pouvant être prélevée au début de l'opération de charge,
selon lequel, au début d'une opération de décharge, on détermine la tension initiale (UE_{Beginn}) de la batterie, l'intensité de courant de décharge et la température de la batterie,
selon lequel, à partir de là, en comparant avec les données présentes dans le réseau de caractéristiques, on choisit une courbe caractéristique et on fixe un état initial de la batterie,
selon lequel, à la fin de l'opération de décharge, on mesure la tension finale (UE_{Mess}) de la batterie,
selon lequel on compare la tension finale (UE_{Mess}) à la tension (UE_{Erwartet}), escomptée d'après la courbe caractéristique choisie, à la fin de la décharge et
selon lequel, si la tension finale (UE_{Mess}) est inférieure à la tension (UE_{Erwartet}), escomptée d'après la courbe caractéristique choisie, à la fin de l'opération de décharge, on détermine que la capacité réelle de la batterie est inférieure à la capacité supposée pouvant être prélevée au début de l'opération de décharge,
selon lequel on prend en compte les résultats de l'opération de charge et les résultats de l'opération de décharge, avec une pondération identique, pour la détermination de la capacité réelle de la batterie.

2. Procédé selon la revendication 1, selon lequel, pour le calcul de la quantité de courant de charge reçue, on cumule séparément une quantité de courant de décharge et la quantité de courant de charge envoyée, on forme un facteur de charge en tant que quotient de la quantité de courant de charge envoyée / quantité de courant de décharge et on divise la quantité de courant de charge envoyée par le facteur de charge.

3. Procédé selon l'une des revendications précédentes, selon lequel la détermination de la capacité réelle de la batterie s'effectue en répétant plusieurs fois successivement les étapes selon la revendication 1 et en effectuant une évaluation de la différence déterminée entre la tension finale (UL_{Mess}, UE_{Mess}) et la tension escomptée (UL_{Erwarter}, UE_{Erwartet}).

4. Procédé selon la revendication 3, selon lequel la détermination de la capacité réelle de la batterie s'effectue après que les étapes selon la revendication 1 ont été réalisées au moins 5 fois successivement.

5. Procédé selon l'une des revendications précédentes, selon lequel, dans un système de coordonnées à deux dimensions, on enregistre la tension initiale (UL_{Beginn}, UE_{Beginn}) et la tension finale (UL_{Mess}, UE_{Mess}) de la batterie par rapport au temps en fonction de la quantité de charge reçue ou prélevée ainsi que la tension escomptée (UL_{Erwarter}, UE_{Erwartet}) par rapport au temps en fonction de la quantité de charge reçue ou prélevée, on détermine la pente de la ligne de jonction entre la tension initiale (UL_{Biginn}, UE_{Beginn}) et la tension finale (UL_{Mess}, UE_{Mess}) ainsi que la pente de la ligne de jonction entre la tension initiale (UL_{Beginn}, UE_{Beginn}) et la tension escomptée (UL_{Erwarter}, UE_{Erwartet}), on détermine la différence des pentes des lignes de jonction ou l'angle entre les lignes de jonction (ϕ) et on l'utilise pour la détermination de la capacité nominale, pouvant être prélevée, disponible et/ou réelle.

6. Procédé selon l'une des revendications précédentes, selon lequel, si la détermination de la capacité réelle a donné une capacité réelle réduite en comparaison d'une batterie à l'état neuf, on mémorise dans une mémoire une capacité nominale, pouvant être prélevée, disponible et/ou réelle, réduite.

7. Procédé selon l'une des revendications précédentes, selon lequel, si la détermination de la capacité réelle a donné une capacité réelle réduite en comparaison d'une batterie à l'état neuf, on soustrait de la grandeur de la capacité nominale, pouvant être prélevée et/ou disponible une valeur prescriptible pour un réseau de caractéristiques décrit par une formule mathématique ou pour une courbe caractéristique décrite par une formule mathématique.

8. Procédé selon l'une des revendications 6 ou 7, **caractérisé en ce que** l'on n'utilise pas intégralement la réduction déterminée de la capacité réelle pour évaluer la capacité nominale, pouvant être prélevée et/ou disponible.

9. Dispositif pour déterminer la capacité réelle d'une batterie avec une mémoire, un dispositif de mesure de tension, un dispositif de mesure de courant, un dispositif de mesure de température et une unité de calcul ainsi qu'un programme informatique exécutable sur celle-ci,
la mémoire étant conçue pour mémoriser ou avoir mémorisé au moins un réseau de caractéristiques d'une batterie,
le dispositif de mesure de tension étant conçu pour mesurer au moins une tension initiale (UL_{Beginn}, UE_{Beginn}) de la batterie au début et une tension finale (UL_{Mess}, UE_{Mess}) de la batterie à la fin d'une opération de charge et d'une opération de décharge,
le dispositif de mesure de courant étant conçu pour mesurer l'intensité d'un courant de charge et de décharge de la batterie,
le dispositif de mesure de température étant conçu pour mesurer la température d'au moins un composant de batterie, et
l'unité de calcul avec le programme informatique exécuté sur celle-ci étant conçue pour déterminer la capacité réelle de la batterie en tenant compte de la tension initiale (UL_{geginn}, UE_{Beginn}), de la tension finale (UL_{Mess}, UE_{Mess}) et de la tension (UL_{Erwartert}, UE_{Erwartert}) escomptée d'après la courbe caractéristique choisie et éventuellement en tenant compte de la quantité de courant de charge reçue de telle sorte que, si la tension finale (UL_{Mess}) est supérieure à la tension (UL_{Erwartert}) escomptée en raison de la courbe caractéristique choisie à la fin de l'opération de charge et si la tension finale (UE_{Mess}) est inférieure à la tension (UE_{Erwartert}) escomptée en raison de la courbe caractéristique choisie à la fin de l'opération de décharge, on détermine que la capacité réelle de la batterie est inférieure à la capacité supposée pouvant être prélevée au début de l'opération de charge et de décharge et on prend en compte les résultats de l'opération de charge et les résultats de l'opération de décharge, avec une pondération identique, pour la détermination de la capacité réelle de la batterie.

10. Dispositif selon la revendication 9, qui est conçu pour réaliser l'un des procédés selon les revendications 2 à 8.
